# FASCICULE DE BREVET EUROPEEN

(11) **EP 1 041 639 B1**
(45) Date de publication et mention de la délivrance du brevet: **03.01.2007**
(21) Numéro de dépôt: 00400703.5
(22) Date de dépôt: 14.03.2000
(51) Int. Cl.: H01L 29/165, H01L 21/336, H01L 31/18, H01L 31/0352, H01L 33/00, H01L 31/072

(54) **Procédé de fabrication d'une hétérostructure planaire**
Verfahren zur Herstellung einer planaren Heterostruktur
Process for fabrication of a planar heterostructure

(30) Priorité: 31.03.1999 FR 9904052
(43) Date de publication de la demande: 04.10.2000
(73) Titulaire: FRANCE TELECOM, 75015 Paris (FR)
(72) Inventeur: Hernandez, Caroline, 38000 Grenoble (FR); Campidelli, Yves, 38000 Grenoble (FR); Rivoire, Maurice, 38240 Meylan (FR); Bensahel, Daniel, 38000 Grenoble (FR)
(74) Mandataire: Casalonga, Axel

(56) Documents cités:
- WO-A-86/03341
- WO-A-97/38442
- US-A- 5 656 514
- SUGIYAMA M ET AL: "A SELECTIVE EPITAXIAL SIGE/SI PLANAR PHOTODETECTOR FOR SI-BASED OEICS" TECHNICAL DIGEST OF THE INTERNATIONAL ELECTRON DEVICES MEETING. (IEDM),US,NEW YORK, IEEE, page 583-586 XP000624770 ISBN: 0-7803-2701-2
- PATENT ABSTRACTS OF JAPAN vol. 017, no. 188 (E-1349), 13 avril 1993 (1993-04-13) -& JP 04 336465 A (MITSUBISHI ELECTRIC CORP), 24 novembre 1992 (1992-11-24)

## Description

La présente invention concerne d'une manière générale un procédé de réalisation d'une hétérostructure planaire pour la fabrication de dispositifs électroniques et/ou optoélectroniques, en particulier dans l'industrie de la microélectronique.

Une des étapes cruciales et souvent limitante des procédés de fabrication des circuits intégrés est l'étape de gravure par photolithographie. Pour réaliser des motifs très minces, typiquement de largeur inférieure à 100 nm, les techniques photolithographiques nécessiteront des équipements très lourds tant financiers que consommateurs de temps, comme l'insolation optique au moyen de rayons X ou l'écriture directe par faisceau électronique.

Il serait donc souhaitable de pouvoir s'affranchir autant que possible pour la fabrication de tels dispositifs microélectroniques, et en particulier pour les dispositifs optoélectroniques, de l'étape de photolithographie.

On a maintenant trouvé qu'il était possible de s'affranchir ou de contourner l'étape photolithographique pour réaliser des motifs en matériau actif (grille d'un CMOS ou couche d'un multi- puits quantiques, par exemple) de largeur prédéterminée très mince en utilisant le très bon contrôle en épaisseur des dépôts. Une telle approche rend possible la réalisation de dispositifs planaires (principalement optoélectroniques), c'est-à-dire en surface de l'échantillon et non plus dans l'épaisseur.

Selon l'invention, le procédé de fabrication d'une hétérostructure planaire comprend :
a) la gravure dans un substrat semiconducteur, à partir d'une surface principale supérieure du substrat,d'au moins une tranchée de largeur et de profondeur prédéterminées ayant une paroi de fond et des parois latérales verticales;
b) le dépôt sur la surface principale supérieure du substrat et les parois de fond et latérales de la tranchée d'un empilement de couches successives et alternées de Si₁₋ₓGeₓ (0 < x ≤1) et Si dont le nombre et l'épaisseur dépendent de l'utilisation finale envisagée pour l'hétérostructure; et
c) le polissage mécano-chimique pour obtenir une hétérostructure finale ayant une surface principale supérieure plane au niveau de laquelle affleurent les couches de l'empilement déposées dans la tranchée.

Dans une première mise en oeuvre du procédé de l'invention l'empilement de couches successives alternées ne remplit pas la tranchée en totalité et avant l'étape de polissage mécano-chimique on procède au dépôt d'une couche d'un matériau diélectrique pour finir le remplissage de la tranchée.

Dans une seconde mise en oeuvre du procédé de l'invention, l'empilement des couches successives alternées dans la tranchée est réalisé de manière à laisser un évidement, par exemple central, dans la tranchée et on procède, avant le polissage mécano-chimique, à une gravure de l'empilement de manière à prolonger l'évidement jusque dans le matériau du substrat. On procède alors au dépôt d'un matériau diélectrique pour remplir l'évidement prolongé et au polissage mécano-chimique pour obtenir l'hétérostructure planaire finale.

Dans une troisième mise en oeuvre du procédé de l'invention,préalablement au dépôt de l'empilement,on dépose dans la tranchée une couche de matériau diélectrique remplissant cette' dernière et on effectue la gravure du matériau diélectrique de façon à former dans la tranchée une cloison, par exemple centrale, divisant la tranchée en deux demi tranchées et on remplit les deux demi tranchées en réalisant le dépôt d'un empilement de couches successives alternées.

Les substrats convenant pour la présente invention sont les substrats en silicium massif ou en couche mince, par exemple silicium sur isolant (SSI), ou en germanium massif ou en couche mince.

Bien évidemment le procédé de l'invention peut comporter la réalisation de plusieurs tranchées dans le substrat en fonction de l'application envisagée pour le dispositif. Les tranchées peuvent être de largeurs identiques ou différentes selon l'application.Egalement la profondeur des tranchées variera en fonction de l'application.

Les parois latérales (flancs) des tranchées sont de préférence verticales, c'est-à-dire le plus proche possible de la direction cristallographique <100> et généralement à un angle de 70° à 80° par rapport au plan de la surface principale supérieure du substrat.Si les flancs des tranchées ne sont pas verticaux, alors on n'obtiendra pas lors du dépôt ultérieur de l'empilement des couches d' épaisseur uniforme sur les flancs, sommets et fonds des tranchées. En outre,les zones en coin au fond ou au sommet des tranchées sont des zones sensibles dans la mesure ou la croissance des couches de l'empilement dans ces zones, bien que conforme, est perturbée. Il est donc préférable d'éloigner ces zones des futures zones actives, par exemple en réalisant des tranchées plus profondes, c'est-à-dire ayant un rapport d'aspect p/e élevé (p=profondeur et e=largeur). De préférence encore les flancs des tranchées seront de qualité monocistalline, c'est-à-dire qu'après la gravure on procèdera à une oxydation des surfaces de la tranchée puis à l'enlèvement de la couche d'oxyde,par exemple par dissolution, pour obtenir des surfaces sans défauts.

Les tranchées peuvent être réalisées par tout procédé classique tel que la photolithogravure au moyen d'un masque.

Le dépôt des couches minces alternées Si₁₋ₓGeₓ et Si est en général un dépôt par hétéro-épitaxie ou épitaxie par voie de dépôt chimique en phase vapeur (CVD). Si le substrat de départ est du silicium ou du silicium sur isolant, la concentration en Ge de l'alliage Si₁₋ₓGeₓ immédiatement déposée sur le substrat peut varier de quelques pourcents à 100% atomique. Néanmoins l'épaisseur de la couche sera telle que cette couche est contrainte sur le substrat de silicium, c'est-à-dire inférieure à l'épaisseur critique au-delà de laquelle la couche se relaxe en émettant des dislocations .Et réciproquement dans le cas d'un dépôt de Si₁₋ₓGeₓ riche en Si sur un substrat de germanium. Le dépôt des différentes couches est réalisé dans des conditions de température, pression, flux d'espèces gazeuses actives permettant d'obtenir une conformité du dépôt, c'est-à-dire une épaisseur constante de chaque film sur la surface, les flancs et le fond de la tranchée. De la précision de l'épaisseur des films sur les flancs de la tranchée dépendra en effet le résultat final en "largeur de trait". Ces dépôts peuvent être réalisés au moyen d'une machine industrielle classique d'épitaxie monoplaque qui s'avère particulièrement appropriée pour former les multicouches Si₁₋ₓGeₓ/Si voulus. On utilisera de préférence des dépôts en régime de surface, c'est-à-dire un régime de dépôt dans lequel c'est la couverture de la surface qui règle l'avancée des réactions chimiques (par opposition au régime de diffusion). Ainsi, avec des gaz précurseurs tels que SiH₄ , GeH₄ et H₂ (ce dernier jouant également le rôle de gaz porteur), on peut utiliser des températures de dépôt variant de 450 à 700°C. Pour obtenir un dépôt conforme,surtout avec des rapports d'aspect élevés, il est préférable d'effectuer le dépôt avec une pression totale faible, typiquement de l'ordre de 2,6 kPa (20 Torr).Toutefois, on peut utiliser des pressions plus élevées allant jusqu'à la pression atmosphérique.

Pour certaines applications, on peut déposer de manière classique, par exemple par CVD, sur la structure avec tranchées remplies,une couche d'un matériau diélectrique, planarisant ou non, tel que SiO₂ ou Si₃N₄.

Eventuellement, les couches épitaxiées ou hétéro-épitaxiées dans les tranchées peuvent être dopées avec un dopant de type n ou p selon l'architecture voulue.

Après les dépôts des différentes couches,on procède au polissage mécano-chimique(PMC) pour faire affleurer les couches à la surface du substrat. On peut utiliser tout procédé PMC classique, les conditions étant déterminées de manière à obtenir uné surface plane quelque soit l'architecture.

Enfin pour encore d'autres applications, on pourra après PMC redéposer sur la surface polie des couches de matériaux tels que Si, SiGe ou diélectriques, par exemple par épitaxie classique.

La suite de la description se réfère aux figures annexées qui représentent respectivement :
Figures 1a à 1d, des vues schématiques en coupe (figures 1a à 1c) et en perspective (figure 1d) des étapes principales d'un mode de mise en oeuvre du procédé de l'invention ;
Figures 2a à 2d, des vues schématiques en coupe (figures 2a à 2d) et en perspectives (figure 2e) des étapes principales d'un second mode de mise en oeuvre du procédé de l'invention ; et
Figures 3a à 3d, des vues schématiques en coupe des étapes principales d'un troisième mode de mise en oeuvre du procédé de l'invention.

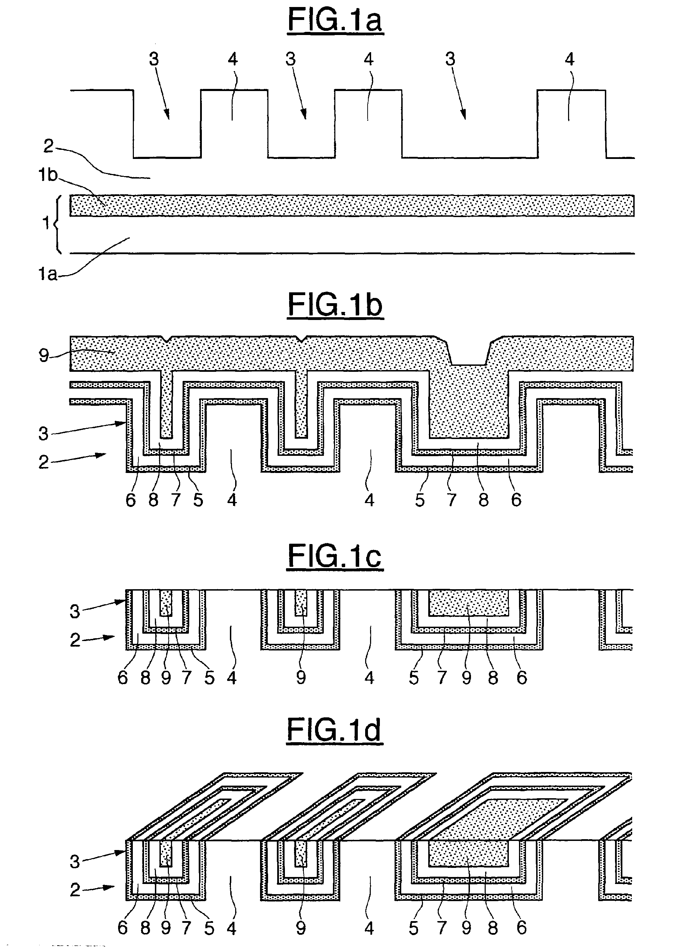

En se référant aux figures 1a à 1d, on va maintenant décrire un premier mode de mise en oeuvre du procédé de l'invention.

Après avoir formé de manière classique, par exemple par épitaxie, sur un substrat 1 tel qu'un substrat "isolant sur silicium (SSI)" comprenant une couche de silicium 1a et une couche d'oxyde de silicium 1b, une couche de silicium ou de germanium 2, on grave de manière classique dans cette couche 2 des tranchées 3 ayant un rapport d'aspect prédéterminé p/e, mais qui peut varier d'une tranchée à l'autre en fonction du dispositif final voulu.

On dépose alors successivement,comme le montre la figure 1b, des couches alternées de Si₁₋ₓGeₓ 5, 7 et Si 6, 8 sur la surface supérieure de la couche 2, plus particulièrement des saillies 4 limitant les tranchées, et les parois des tranchées 3. Bien évidemment le nombre de couches alternées successives dépendra de l'épaisseur de ces couches et du dispositif final voulu.

Dans l'exemple de mise en oeuvre du procédé représenté, les couches successives alternées ne remplissent pas totalement les tranchées mais y laissent un évidement, et on dépose toujours de manière classique, par exemple par CVD, une couche d'un matériau diélectrique 9 tel que du SiO₂ ou du Si₃N₄ de manière à remplir les évidements des tranchées et recouvrir les couches alternées 5 à 8.

A ce stade du procédé on effectue un polissage mécano-chimique classique de façon à enlever des parties superficielles de la couche de matériau diélectrique 9 et des couches successives alternées 5 à 8 pour obtenir une hétérostructure ayant une surface supérieure plane au niveau de laquelle affleurent, comme le montrent les figures 1c et 1d, les couches successives alternées 5 à 8 et la couche de matériau diélectrique 9.

On obtient ainsi à la surface supérieure plane des zones adjacentes de différents matériaux combinés pour réaliser le dispositif voulu. Après réalisation de manière classique de zones de contact prédéterminées, on obtient des dispositifs fonctionnant dans le plan, tels que des puits quantiques permettant une détection à différentes longueurs d'onde avec une illumination normale à la surface, c'est-à-dire sans absorption dans les différentes couches, et ce, grâce à différentes largeurs de tranchées.

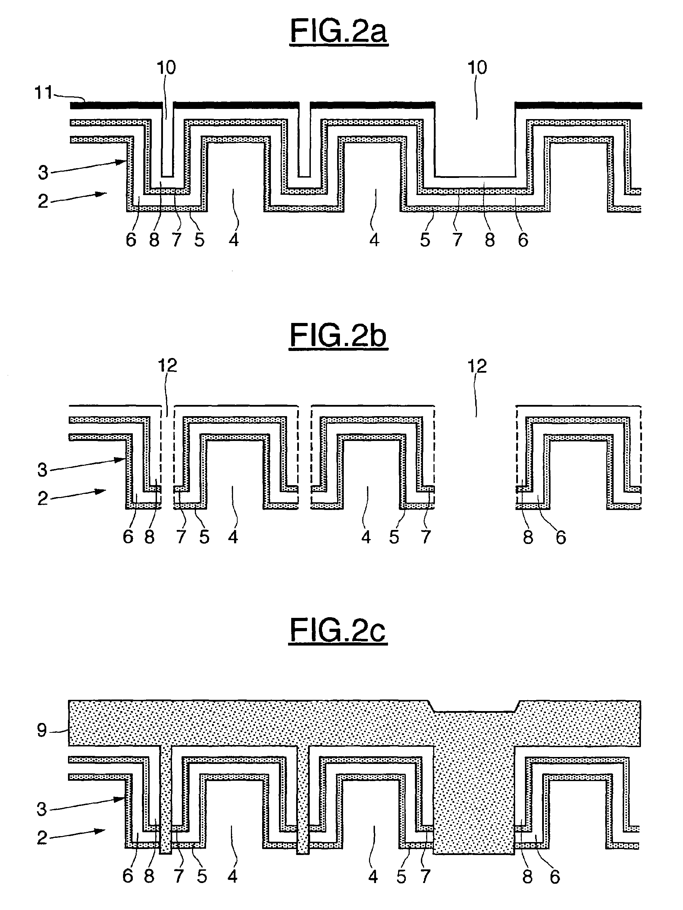

Les figures 2a à 2e, sur lesquelles les mêmes numéros de références représentent les mêmes éléments, illustrent un second mode de mise en oeuvre du procédé de l'invention.

Comme le montre la figure 2a, après avoir réalisé comme précédemment une structure comprenant une couche de Si ou Ge 2 comportant des tranchées 3 et revêtue de couches successives alternées de Si₁₋ₓGeₓ et Si également comme décrit en liaison avec les figures 1a à 1d, on revêt de façon classique , par exemple par photolithographie, la surface supérieure de la structure d'un masque de résine 11 de motif approprié, laissant apparent les parties non remplies ou évidements 10 des tranchées. Cette photolithographie n'est pas critique car elle a lieu en dehors des zones actives du dispositif.

On grave ensuite la structure de manière classique pour dégager les fonds des parties non remplies des tranchées et ainsi former des évidements prolongés 12 pénétrant jusque dans la couche de Si ou Ge 2.

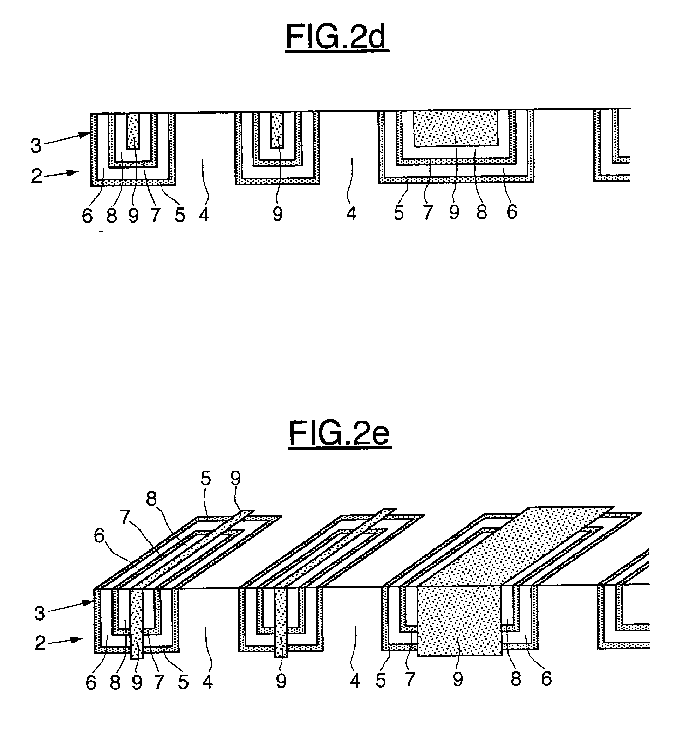

On procède alors comme précédemment en déposant une couche 9 de matériau isolant de manière à remplir les évidements prolongés 12 afin d'isoler les différentes zones actives (figure 2c) et à un polissage mécano-chimique pour obtenir l'hétérostructure planaire représentée aux figures 2d et 2e.

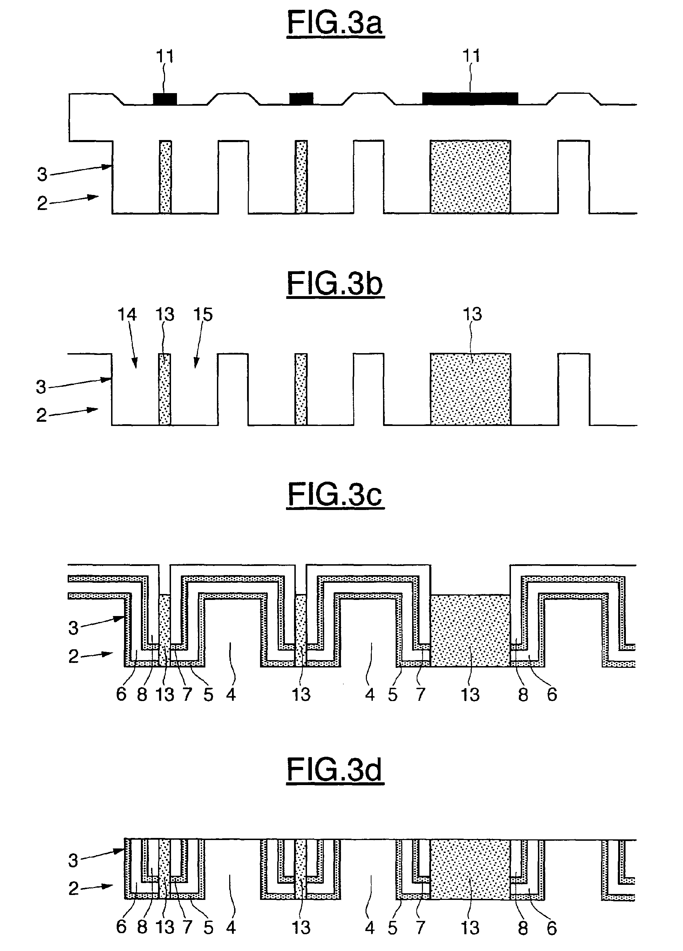

Les figures 3a à 3d, où les mêmes numéros de référence représentent les mêmes éléments, illustrent schématiquement un autre mode de réalisation de l'isolation des zones actives d'une hétérostructure planaire selon l'invention.

Comme le montre la figure 3a, après avoir formé des tranchées dans une couche 2 de Si ou Ge on remplit les tranchées et recouvrent la couche 2 avec un matériau diélectrique 9. Puis on réalise de manière classique sur la couche 9 de matériau diélectrique un motif prédéterminé d'une résine de masquage 11.

Comme le montre la figure 3b, le motif de résine 11 est tel, qu'après gravure, il ne reste de la couche de matériau diélectrique 9 que des éléments 13, par exemple centraux, d'épaisseur prédéterminée divisant les tranchées en deux demi-tranchées 14,15.

On procède alors au dépôt des couches alternées successives de Si et SiGe 5-8 dans les demi-tranchées et sur la surface de la couche 2 (figure 3c) puis à un polissage mécano-chimique pour obtenir l'hétérostructure planaire de la figure 3d.

### Exemples de réalisations à base de multi-puits quantiques.

### -Fabrication de fils quantiques ;

Epaisseurs des couches alternées

| | |
|---|---|
| SiGe (teneur en Ge de 15-20 % at.) | <10 nm |
| Ge | 0,5 à 5 nm |
| Si | ≤10 nm |

Multicouches SiGe/Si :X périodes
Largeur de la tranchée : e = [X(20+10)]x2
Profondeur de la tranchée dans le substrat : p>500 nm (p>e)
PMC jusqu'à affleurement de toutes les couches
Couche d'encapsulation éventuelle en matériau diélectrique ou Si.

### -Détecteur à base de SiGe/Si :

Même structure que ci-dessus avec en plus une alternance de tranchées à pas variable adjacentes dont la somme est inférieure à l'aire du spot lumineux (Réalisation de matrices de détection).

### -Fabrication d'une structure laser à base de Si ;

Même structure que précédemment mais en ayant des largeurs de tranchées pour obtenir les trois niveaux de pompage d'une émission laser dans le plan.

## Revendications

1. Procédé de fabrication d'une hétérostucture planaire, **caractérisé en ce qu'**il comprend :
a) la gravure dans un substrat semiconducteur (2), à partir d'une sur face principale supérieure du substrat,d'au moins une tranchée de largeur et de profondeur prédéterminées ayant une paroi de fond et des parois latérales verticales;
b) le dépôt sur la surface principale supérieure du substrat et les parois de fond et latérales de la tranchée d'un empilement de couches successives et alternées de Si₁₋ₓGeₓ (0 < x ≤ 1) et Si (5-8) dont le nombre et l'épaisseur dépendent de l'utilisation finale envisagée pour l'hétérostructure;et
c)le polissage mécano-chimique pour obtenir une hétérostructure finale ayant une surface principale supérieure plane au niveau de laquelle affleurent les couches de l'empilement déposées dans la tranchée.

2. Procédé selon la revendication 1, **caractérisé en ce que** l'empilement de couches successives alternées ne remplit pas la tranchée en totalité et **en ce qu'**il comprend en outre, avant l'étape de polissage mécano-chimique, le dépôt d'une couche (9) de matériau diélectrique pour remplir la tranchée.

3. Procédé selon la revendication 1, **caractérisé en ce que** l'empilement de couches successives alternées (5-8) dans la tranchée (3) laisse un évidement (10) dans la tranchée et **en ce que**, avant l'étape de polissage mécano-chimique, on effectue une gravure de l'empilement de manière à prolonger l'évidement jusque dans le matériau du substrat et on dépose une couche de matériau diélectrique (9) de façon à remplir l'évidement prolongé (12).

4. Procédé selon la revendication 1, **caractérisé en ce que** préalablement au dépôt de l'empilement, on dépose une couche de matériau diélectrique (9) remplissant la tranchée (3), on effectue une gravure du matériau diélectrique pour former dans la tranchée un élément (13) d'épaisseur prédéterminée divisant la tranchée en deux demi-tranchées et on remplit les deux demi-tranchées en procédant au dépôt de l'étape (b).

5. Procédé selon l'une quelconque des revendications 1 à 4, **caractérisé en ce qu'**il comprend :
la gravure de plusieurs tranchées de largeurs identiques ou différentes.

6. Procédé selon l'une quelconque des revendications 1 à 5, **caractérisé en ce que** le substrat est un substrat massif de silicium ou de germanium.

7. Procédé selon l'une quelconque des revendications 1 à 5, **caractérisé en ce que** le substrat est un substrat de silicium sur isolant (SSI).

8. Procédé selon l'une quelconque des revendications 1 à 7, **caractérisé en ce qu'**il comprend, après la gravure de la tranchée, une étape d'oxydation des parois de la tranchée et une étape d'élimination de l'oxyde formé.

## Claims

1. Process for fabricating a planar it comprises:
a) etching, in a semiconductor substrate (2) and starting from an upper main surface of the substrate, at least one trench with predetermined width and depth having a bottom wall and vertical side walls;
b) depositing, on the upper main surface of the substrate and the bottom and side walls of the trench, a stack of successive and alternate layers of Si₁₋ₓGeₓ 10<x≤1) and Si (5-8), the number and the thickness of which depend on the final use intended for the heterostructure; and
c) chemical-mechanical polishing in order to obtain a final heterostructure having a plane upper main surface, level with which the stack layers deposited in the trench are flush.

2. Process according to Claim 1, **characterized in that** the stack of successive alternate layers does not fill the trench completely, and **in that** it furthermore comprises, before the chemical-mechanical polishing step, depositing a layer (9) of dielectric material in order to fill the trench.

3. Process according to Claim 1, **characterized in that** the stack of successive alternate layers (5-8) in the trench (3) leaves a recess (10) in the trench, and **in that**, before the chemical-mechanical polishing step, the stack is etched so as to extend the recess down into the material of the substrate, and a layer of dielectric material (9) is deposited so as to fill the extended recess (12).

4. Process according to Claim 1, **characterized in that**, prior to the deposition of the stack, a layer of dielectric material (9) filling the trench (3) is deposited, the dielectric material is etched in order to form, in the trench, an element (13) with predetermined thickness dividing the trench into two half-trenches, and the two half-trenches are filled by carrying out the deposition in step (b).

5. Process according to anyone of Claims 1 to 4, **characterized in that** it comprises:
etching a plurality of trenches with identical or different widths.

6. Process according to anyone of Claims 1 to 5, **characterized in that** the substrate is a silicon or germanium bulk substrate.

7. Process according to anyone of Claims 1 to 5, **characterized in that** the substrate is a silicon-on-insulator (SOI) substrate.

8. Process according to anyone of Claims 1 to 7, **characterized in that** it comprises, after etching the trench, a step of oxidizing the walls of the trench and a step of removing the oxide formed.

## Patentansprüche

1. Verfahren zur Herstellung einer planaren Heterostruktur, **dadurch gekennzeichnet, dass** hierzu gehört:
a) in einen Halbleitersubstrat (2) wird, ausgehend von einer oberen Hauptfläche des Substrates wenigstens ein Graben eingearbeitet, mit einer vorbestimmten Breite und einer vorbestimmten Tiefe, der einen Boden und vertikale Seitenwände aufweist:
b) auf die obere Hauptfläche des Substrates, den Boden und die Seitenwände des Grabens, wird eine Stapel von aufeinander folgend und abwechselnden Schichten aus Si₁₋ₓGeₓ(0<X≤1) und Si(5-8) aufgebracht, deren Anzahl und Dicke von der schließlich beabsichtigten Verwendung der Heterostruktur abhängig ist und
c) es wird mechanisch-chemisch poliert um eine endgültige Heterostruktur zu erzeugen, die eine obere Haupflächenebene auf einer Höhe aufweist, dass sie den Stapel der aufeinander liegend abgelagerten Schichten in dem Graben berührt.

2. Verfahren nach Anspruch 1, **dadurch gekennzeichnet, dass** der Stapel der aufeinander folgend abwechselnden Schichten den Graben nicht zur Gänze füllt und dass es außerdem zu dem Verfahren gehört, dass vor dem mechanisch chemischen Polierschritt eine Schicht (9) aus dielektrischem Material zum Auffüllen des Grabens aufgebracht wird.

3. Verfahren nach Anspruch 1, **dadurch gekennzeichnet, dass** der Stapel aus aufeinander folgend abwechselnden Schichten 5-8 in dem Graben (3) einen Freiraum (10) in dem Graben lässt und dass vor dem Schritt des mechanisch chemischen Polierens eine Struktur in dem Stapel in der Weise eingebracht wird, dass der Freiraum bis in das Substratmaterial reicht und dass eine Schicht aus dielektrischem Material (9) aufgebracht wird, um den vertieften Freiraum 12 zu füllen.

4. Verfahren nach Anspruch 1, **dadurch gekennzeichnet, dass** vor dem Aufbringen des Stapels eine Schicht aus dielektrischem Material (9), das den Graben (3) füllt, aufgebracht wird, dass das dielektrische Material abgetragen wird, um in dem Graben ein Strukturelement (13) mit einer vorbestimmten Dicke zu erzeugen, das den Graben in zwei Teilgräben aufteilt, und dass die beiden Teilgräben gefüllt werden, indem der Ablagerungsschritt (b) ausgeführt wird.

5. Verfahren nach einem der Ansprüche 1 bis 4, **dadurch gekennzeichnet, dass** hierzu gehört:
eine Anzahl von Gräben mit gleicher oder unterschiedlicher Breite wird eingearbeitet.

6. Verfahren nach einem der Ansprüche 1 bis 5, **dadurch gekennzeichnet, dass** das Substrat ein massives Siliciumsubstrat oder Germaniumsubstrat ist.

7. Verfahren nach einem der Ansprüche 1 bis 5, **dadurch gekennzeichnet, dass** das Substrat ein Siliciumsubstrat auf einer Isolierschicht ist. (SSI).

8. Verfahren nach einem der Ansprüche 1 bis 7, **dadurch gekennzeichnet, dass** hierzu die Schritte gehören, dass nach dem Einarbeiten des Grabens die Wände des Grabens oxidiert werden und dass das gebildete Oxid beseitigt wird.
